# EUROPEAN PATENT APPLICATION

(11) **EP 2 328 184 A1**
(43) Date of publication of application: **01.06.2011**
(21) Application number: 09812900.0
(22) Date of filing: 10.09.2009
(51) Int. Cl.: H01L 31/04

(54) **SOLAR CELL AND SOLAR CELL MANUFACTURING METHOD THEREFOR**

(30) Priority: 12.09.2008 JP 2008235067
(71) Applicant: ULVAC, INC., Chigasaki-shi Kanagawa 253-8543 (JP)
(72) Inventor: WATAI, Miwa, Sammu-shi Chiba 289-1226 (JP); SAITO, Kazuya, Sammu-shi Chiba 289-1226 (JP); KOMATSU, Takashi, Sammu-shi Chiba 289-1226 (JP); KUROIWA, Shunji, Sammu-shi Chiba 289-1226 (JP); MIZUNO, Yusuke, Sammu-shi Chiba 289-1226 (JP); SAKIO, Susumu, Sammu-shi Chiba 289-1226 (JP); HIRAOKA, Kensuke, Sammu-shi Chiba 289-1226 (JP)
(74) Representative: Eisenführ, Speiser & Partner
(86) International application number: PCT/JP2009/004499
(87) International publication number: WO 2010/029751

(57) **Abstract**

A solar cell includes: a photoelectric converter in which a first electrode layer, a photoelectric conversion layer, and a second electrode layer are stacked on a substrate in order; and a texture layer that is disposed between the substrate and the first electrode layer, made of a transparent material in a visible light region, and has a continuous irregular configuration on a face that is in touch with the first electrode layer.

## Description

### BACKGROUND OF THE INVENTION

### Field of the Invention

The present invention relates to a solar cell and a solar cell manufacturing method. This application claims priority from Japanese Patent Application No. 2008-235067 filed on September 12, 2008, the contents of which are incorporated herein by reference in their entirety.

### Background Art

In recent years, in view of efficient use of energy, solar cells are more widely used than ever before.

As solar cells, silicon-series solar cells such as a silicon solar cell employing single-crystalline silicon, a polysilicon solar cell employing a polysilicon layer, or an amorphous silicon solar cell employing amorphous silicon are known.

A silicon-series solar cell is constituted of a photoelectric converter in which, for example, a top-face electrode which serves as a transparent electrode and is formed on a glass substrate, a semiconductor layer (photoelectric conversion layer) which is formed on the top-face electrode and composed of silicon, and an Ag thin film which becomes a back-face electrode are stacked in layers.

The semiconductor layer is formed of a layered structure which is referred to as pin-junction in which a silicon film (i-type) is sandwiched between p-type and n-type silicon films, the silicon film (i-type) generating electrons and holes when receiving light.

Meanwhile, in order to improve conversion efficiency of the optical energy, it is known that a texture structure that has an uneven structure and is located at a boundary face between a top-face electrode and a semiconductor layer is employed in the above-described constitution of the solar cell.

With this configuration, due to realizing reduction in optical reflectance at the boundary face between the top-face electrode and the semiconductor layer, it is possible to obtain a prismatic effect that the optical path of sunlight incident to the top-face electrode is extended and a light confining effect, and a photo-electric current can be improved.

As a solar cell employing the texture structure, for example, a constitution described below is known.

It is known that a method of forming a top-face electrode (transparent-electroconductive film) composed of SnO₂ by a tin-plating or a CVD (Chemical Vapor Deposition), thereafter, forming irregularity on a surface of the top-face electrode by utilizing heat generated in the process thereof as disclosed in, for example, Japanese Unexamined Patent Application, First Publication No. 2000-340815.

In this case, a method of appropriately polishing the top-face electrode formed by a CVD method by wet-polishing using a loose grind stone so as to form irregularity is also known (for example, refer to Japanese Unexamined Patent Application, First Publication No. 2006-5021).

Moreover, a constitution in which an island shaped layer composed of SnO₂ or the like having a hemisphere shape is formed between a substrate and a top-face electrode (electroconductive layer) is known as disclosed in, for example, PCT International Publication No. WO 2005/27229.

However, in the above-described constitutions of Japanese Unexamined Patent Application, First Publication No. 2000-340815 and Japanese Unexamined Patent Application, First Publication No. 2006-5021, since irregular configuration is formed on the top-face electrode itself, a top-face electrode is formed so that the thickness thereof should be relatively thick (for example, approximately from 0.8 µm to 11µm).

When the top-face electrode is formed so that the thickness thereof is thick, the optical transmittance of the top-face electrode decreases, and the amount of light incident to a semiconductor layer becomes low.

As a result, since the absorbed amount of sunlight in the semiconductor layer decreases, there is a problem in that the conversion efficiency of a solar cell becomes low.

In addition, a structure in which an and shaped layer is formed on a high refractive index layer and a low refractive index layer is disclosed in PCT International Publication No. WO 2005/27229, and a process is thereby necessary for forming the high refractive index layer and the low refractive index layer.

As a result, there is a problem in that it is difficult to eliminate the cost of manufacturing.

Additionally, a structure which is disclosed in, for example, Japanese Unexamined Patent Application, First Publication No. 2004-31648 and Japanese Unexamined Patent Application, First Publication No. 2003-179241 is known as a conventional texture structure.

Moreover, a method which is disclosed in, for example, Japanese Unexamined Patent Application, First Publication No. 2008-53273 and Japanese Unexamined Patent Application, First Publication No. 2008-218191 is known as a method for forming a conventional texture structure.
a method of preparing a mold which has an uneven face and is formed by dispersing and combining fine-particles made of silica, pressing the mold having the uneven face onto a substrate, transforming the substrate surface by directly transferring the shape of the uneven face of the mold to the substrate, and thereby forming a texture structure on the substrate is disclosed in Japanese Unexamined Patent Application, First Publication No. 2008-218191.

Consequently, the present invention was made in order to solve the above problems, and has an object to provide a solar cell manufacturing method and solar cell having a texture structure while improving an optical transmittance in a first electrode layer.

### SUMMARY OF THE INVENTION

In order to solve the above-described problem, a solar cell of a first aspect of the present invention includes: a photoelectric converter in which a first electrode layer, a photoelectric conversion layer, and a second electrode layer are stacked on a substrate in order; and a texture layer that is disposed between the substrate and the first electrode layer, made of a transparent material in a visible light region, and has a continuous irregular configuration on a face that is in touch with the first electrode layer.

With this configuration, by forming the texture layer separated from the first electrode layer between the substrate and the first electrode layer, the first electrode layer formed on the texture layer has an irregular configuration along the shape of the texture layer.

Consequently, it is possible to provide a solar cell with a texture structure having excellent prismatic effect that the optical path of sunlight is extended, light confining effect, or the like.

Because of this, unlike a conventional method, it is not necessary to form the first electrode layer so that the film thickness thereof is thick in order to form an irregular configuration on a top face of the first electrode layer.

Namely, since the first electrode layer can be formed so that the film thickness thereof is thin, it is possible to improve the optical transmittance in a first electrode layer and to increase the influx amount of sunlight incident to a photoelectric conversion layer.

Therefore, the absorbed amount of sunlight in the photoelectric conversion layer increases, and it is possible to improve the conversion efficiency of a solar cell.

Furthermore, by continuously forming the irregular configuration on the substrate in a direction parallel to the substrate, it is possible to prevent a flat face from being formed on the first electrode layer formed on the texture layer.

For this reason, since it is possible to obtain a prismatic effect that the optical path of sunlight is extended, a light confining effect, or the like at the entire of face of the substrate, and it is thereby possible to improve the conversion efficiency of a solar cell.

Moreover, since it is possible to eliminate the amount used of the first electrode layer by forming the first electrode layer so that the film thickness thereof is thin, it is possible to reduce the cost of manufacturing a solar cell and it is also possible to improve the manufacturing efficiency.

Also, since the texture layer is directly formed on the substrate, it is not necessary to form a high refractive index layer and a low refractive index layer unlike PCT International Publication No. WO 2005/27229, and the effect is thereby obtained that it is possible to reduce the cost of manufacturing a solar cell.

Additionally, since it is possible to obtain a preferred refractive index by controlling the irregular configuration of the texture layer (uneven portion, protuberance portion, recessed portion) so as to be a desired shape, the texture layer can serve as a refractive index controlling layer.

In the solar cell of the first aspect of the present invention, a texture layer is not formed by deforming the substrate surface, in other words, the texture layer in which a substrate and a texture layer are integrated is not formed.

In the solar cell of the present invention, since a texture layer is formed using a transparent material arranged on the substrate, it is possible to appropriately select a structure of the texture layer so as to obtain a desired conversion efficiency by adequately selecting a kind of the material of the texture layer or the like and using a method of disposing a material that becomes a texture layer on a substrate.

Additionally, in the solar cell of the first aspect of the present invention, it is preferable that, when refractive indexes in a visible light region, of the substrate, the texture layer, and the first electrode layer is defined as n0, n1, and n2, respectively, n0 < n1 < n2 be satisfied.

With this configuration, since reflection of incidence light is suppressed at a boundary face between the substrate and the texture layer and between the texture layer and the first electrode layer, it is possible to obtain a texture due to the first electrode layer having a high degree of light confining effect in spite of the thickness thereof being less than the conventional thickness, and it is possible to manufacture a solar cell having a further high level of conversion efficiency.

Additionally, in the texture layer of the solar cell of the first aspect of the present invention, it is preferable that a distance between top portions adjacent to each other in the texture layer be from 0.1 µm to 10 µm, and a film thickness of the first electrode layer be from 0.2 µm to 0.5 µm.

In the case where both the distance between the top portions and the height thereof is less than 0.1 µm, it is not possible to form a desired texture structure at the first electrode layer formed on the texture layer, a prismatic effect or a light confining effect is not anticipated, and the case is thereby undesired.

Additionally, when the film thickness of the first electrode layer is less than 0.2 µm, there is a concern that the conductivity thereof cannot ensured, and it is thereby undesirable.

On the other hand, when the distance between the top portions is greater than 10 µm, the height of the top portion is greater than 0.5 µm, the first electrode layer is formed so that the film thickness thereof is greater than 0.5 µm, the film thicknesses of the first electrode layer and the texture layer are thick and there is a concern that the optical transmittance is degraded, and it is thereby undesirable.

In contrast, according to the constitution of the present invention, it is possible to form a desired texture structure at the first electrode layer, it is possible to improve the optical transmittance of the first electrode layer and the texture layer in addition to securing of the conductivity of the first electrode layer.

Furthermore, a solar cell manufacturing method of a second aspect of the present invention is a method for manufacturing a solar cell having a photoelectric converter in which a first electrode layer, a photoelectric conversion layer, and a second electrode layer are stacked on a substrate in order, the method including a step of forming a texture layer forming a continuous irregular configuration on the substrate by use of a transparent material in a visible light region before forming the first electrode layer.
The forming of the texture layer includes: a step of applying the transparent material on the substrate; and a step of forming an irregular configuration by pressing a mold having a pattern onto the transparent material applied on the substrate such that the pattern is transferred to the transparent material.

According to the method, by forming the first electrode layer on the texture layer after the texture layer is formed on the substrate, an irregularity is formed in the first electrode layer along the shape of the texture layer.

Consequently, it is possible to manufacture a solar cell with a texture structure having excellent prismatic effect that the optical path of sunlight is extended, light confining effect, or the like.

Specifically, by transferring a pattern of the texture layer to a transparent material (liquid material) which is applied on the substrate using a nanoimprint method, it is possible to easily form the texture layer on the substrate in a direction parallel to the substrate in a continuous manner.

Because of this, unlike a conventional method, it is not necessary to form the first electrode layer so that the film thickness thereof is thick in order to form an irregular configuration on a top face of the first electrode layer.

Namely, since the first electrode layer can be formed so that the film thickness thereof is thin, it is possible to improve the optical transmittance in a first electrode layer and to increase the influx amount of sunlight incident to a photoelectric conversion layer.

Therefore, the absorbed amount of sunlight in the photoelectric conversion layer increases, and it is possible to improve the conversion efficiency of a solar cell.

Additionally, by forming a continuous irregular configuration on the substrate in a direction parallel to the substrate, it is possible to prevent a flat face from being formed on the first electrode layer to be formed on the texture layer.

For this reason, since it is possible to obtain a prismatic effect that the optical path of sunlight is extended, a light confining effect, or the like at the entire of face of the substrate, and it is thereby possible to improve the conversion efficiency of a solar cell.

Moreover, since it is possible to eliminate the amount used of the first electrode layer by forming the first electrode layer so that the film thickness thereof is thin, it is possible to reduce the cost of manufacturing a solar cell and it is also possible to improve the manufacturing efficiency.

Also, since the texture layer is directly formed on the substrate, it is not necessary to form a high refractive index layer and a low refractive index layer unlike PCT International Publication No. WO 2005/27229, and the effect is thereby obtained that it is possible to reduce the cost of manufacturing a solar cell.

Additionally, since it is possible to obtain a preferred refractive index by controlling the irregular configuration of the texture layer (uneven portion) so as to be a desired shape, the texture layer can serve as a refractive index controlling layer.

In the solar cell manufacturing method of the second aspect of the present invention, a texture layer is not formed by deforming the substrate surface, in other words, the texture layer in which a substrate and a texture layer are integrated is not formed.

In the solar cell manufacturing method of the present invention, the pattern is transferred to the transparent material by applying a transparent material onto the substrate and by pressing the mold having a pattern onto the transparent material applied on the substrate, and an irregular configuration is thereby formed.

Because of this, by adequately selecting a pattern shape (for example, random pattern) formed on the mold, material type of the texture layer, or the like, it is possible to appropriately select a structure of the texture layer so as to obtain a desired conversion efficiency.

Furthermore, a solar cell manufacturing method of a third aspect of the present invention is a method for manufacturing a solar cell having a photoelectric converter in which a first electrode layer, a photoelectric conversion layer, and a second electrode layer are stacked on a substrate in order, the method including a step of forming a texture layer forming a continuous irregular configuration on the substrate by use of a transparent material in a visible light region before forming the first electrode layer.
The forming of the texture layer includes forming a continuous irregular configuration by applying the transparent material on the substrate using an inkjet apparatus.

According to the method, by forming the first electrode layer on the texture layer after the texture layer is formed on the substrate, an irregularity is formed in the first electrode layer along the shape of the texture layer.

Consequently, it is possible to manufacture a solar cell with a texture structure having excellent prismatic effect that the optical path of sunlight is extended, light confining effect, or the like.

Specifically, it is possible to continuously and easily form a texture layer on the substrate in a direction parallel to the substrate by applying droplets made of the transparent material (liquid material) using an inkjet apparatus.

Moreover, by further applying droplets on the droplets which are formed on the substrate in advance, it is possible to continuously dispose the droplets in a direction vertical to the substrate face.

Also, since the texture layer is directly formed on the substrate, it is not necessary to form a high refractive index layer and a low refractive index layer unlike PCT International Publication No. WO 2005/27229, and the effect is thereby obtained that it is possible to reduce the cost of manufacturing a solar cell.

Additionally, since it is possible to obtain a preferred refractive index by controlling the irregular configuration of the texture layer (uneven portion) so as to be a desired shape, the texture layer can serve as a refractive index controlling layer.

In the solar cell manufacturing method of the third aspect of the present invention, a texture layer is not formed by deforming the substrate surface, in other words, the texture layer in which a substrate and a texture layer are integrated is not formed.

In the solar cell manufacturing method of the present invention, a transparent material is applied by use of an inkjet apparatus, and a continuous irregular configuration is thereby formed.

For this reason, by adequately selecting the ejection rate of a droplet made of the transparent material, the position at which the droplet is disposed on the substrate, material type of the texture layer or the like, it is possible to appropriately select a structure of the texture layer so as to obtain a desired conversion efficiency.

Furthermore, a solar cell manufacturing method of a fourth aspect of the present invention is a method for manufacturing a solar cell having a photoelectric converter in which a first electrode layer, a photoelectric conversion layer, and a second electrode layer are stacked on a substrate in order, the method including a step of forming a texture layer forming a continuous irregular configuration on the substrate by use of a transparent material in a visible light region before forming the first electrode layer. The forming of the texture layer includes forming the texture layer having an irregular configuration by applying the transparent material on the substrate using a spray.

According to the method, by forming the first electrode layer on the texture layer after the texture layer is formed on the substrate, an irregularity is formed in the first electrode layer along the shape of the texture layer.

Consequently, it is possible to manufacture a solar cell with a texture structure having excellent prismatic effect that the optical path of sunlight is extended, light confining effect, or the like.

Specifically, by applying droplets made of the transparent material (liquid material) by use of a spray, it is possible to easily form the texture layer on the substrate in a direction parallel to the substrate in a continuous manner.

Also, since the texture layer is directly formed on the substrate, it is not necessary to form a high refractive index layer and a low refractive index layer unlike PCT International Publication No. WO 2005/27229, and the effect is thereby obtained that it is possible to reduce the cost of manufacturing a solar cell.

Additionally, since it is possible to obtain a preferred refractive index by controlling the irregular configuration of the texture layer (uneven portion) so as to be a desired shape, the texture layer can serve as a refractive index controlling layer.

In the solar cell manufacturing method of the fourth aspect of the present invention, a texture layer is not formed by deforming the substrate surface, in other words, the texture layer in which a substrate and a texture layer are integrated is not formed.

In the solar cell manufacturing method of the present invention, the texture layer having an irregular configuration is formed by spraying a transparent material using a spray.

Because of this, by adequately selecting a diameter of the droplet to be sprayed, the distance between a liquid spray head (spray) and a substrate, material type of the texture layer, or the like, it is possible to appropriately select a structure of the texture layer so as to obtain a desired conversion efficiency.

### Effects of the Invention

According to the present invention, by forming the texture layer separated from the first electrode layer between the substrate and the first electrode layer, the first electrode layer formed on the texture layer forms an irregular configuration along the shape of the texture layer.

Consequently, it is possible to provide a solar cell with a texture structure having excellent prismatic effect that the optical path of sunlight is extended, light confining effect, or the like.

Because of this, unlike a conventional method, it is not necessary to form the first electrode layer so that the film thickness thereof is thick in order to form a texture on a top face of the first electrode layer.

Namely, since the first electrode layer can be formed so that the film thickness thereof is thin, it is possible to improve the optical transmittance in a first electrode layer and to increase the influx amount of sunlight incident to a photoelectric conversion layer.

Therefore, the absorbed amount of sunlight in the photoelectric conversion layer increases, and it is possible to improve the conversion efficiency of a solar cell.

Furthermore, by continuously forming the irregular configuration on the substrate in a direction parallel to the substrate, it is possible to prevent a flat face from being formed on the first electrode layer formed on the texture layer.

For this reason, since it is possible to obtain a prismatic effect that the optical path of sunlight is extended, a light confining effect, or the like at the entire of face of the substrate, and it is thereby possible to improve the conversion efficiency of a solar cell.

Moreover, since it is possible to eliminate the amount used of the first electrode layer by forming the first electrode layer so that the film thickness thereof is thin, it is possible to reduce the cost of manufacturing a solar cell and it is also possible to improve the manufacturing efficiency.

### BRIEF DESCRIPTION OF THE DRAWINGS

FIG. 1 is a cross-sectional view showing an amorphous silicon type solar cell of a first embodiment of the present invention.
FIG. 2A is a flow sheet showing a method for manufacturing an amorphous silicon type solar cell of the first embodiment of the present invention and is a view illustrating a method for forming a texture layer.
FIG. 2B is a flow sheet showing the method for manufacturing an amorphous silicon type solar cell of the first embodiment of the present invention and is a view illustrating a method for forming a texture layer.
FIG. 2C is a flow sheet showing the method for manufacturing an amorphous silicon type solar cell of the first embodiment of the present invention.
FIG. 2D is a flow sheet showing the method for manufacturing an amorphous silicon type solar cell of the first embodiment of the present invention.
FIG. 3A is an enlarged view illustrating a texture layer of the first embodiment of the present invention and is a view showing the texture layer that was obtained by an experiment.
FIG. 3B is a view illustrating the texture layer of the first embodiment of the present invention and is a view showing a profile corresponding to FIG. 3A which was obtained by the experiment.
FIG. 3C is a perspective view illustrating the texture layer of the first embodiment of the present invention and is a view showing the texture layer that was obtained by an experiment.
FIG. 3D is a perspective view illustrating the texture layer of the first embodiment of the present invention and is a view showing the texture layer that was obtained by an experiment.
FIG. 4A is a cross-sectional view showing an apparatus which is used in a texture layer formation step of a second embodiment of the present invention.
FIG. 4B is a plan view showing the apparatus which is used in the texture layer formation step of the second embodiment of the present invention.
FIG. 5A is a flow sheet showing the texture layer formation step of the second embodiment of the present invention and is a view showing a step of forming the texture layer.
FIG. 5B is a flow sheet showing the texture layer formation step of the second embodiment of the present invention and is a view showing the step of forming the texture layer.
FIG. 5C is a flow sheet showing the texture layer formation step of the second embodiment of the present invention and is a view showing the step of forming the texture layer.
FIG. 6A is a flow sheet showing a modified example of the texture layer formation step of the second embodiment of the present invention and is a view showing a step of forming the texture layer.
FIG. 6B is a flow sheet showing a modified example of the texture layer formation step of the second embodiment of the present invention and is a view showing the step of forming the texture layer.
FIG. 6C is a flow sheet showing a modified example of the texture layer formation step of the second embodiment of the present invention and is a view showing the step of forming the texture layer.
FIG. 7A is a side view illustrating a texture layer formation step of a third embodiment of the present invention and is a side view illustrating a method for forming the texture layer.
FIG. 7B is a plan view illustrating a texture layer formation step of a third embodiment of the present invention and is a plan view illustrating a method for forming the texture layer.
FIG. 7C is a plan view illustrating a first modified example of the texture layer formation step of the third embodiment of the present invention and is a view illustrating a method for forming the texture layer.
FIG. 7D is a side view illustrating a second modified example of the texture layer formation step of the third embodiment of the present invention and is a view illustrating a method for forming the texture layer.
FIG. 8A is a view illustrating a texture layer of the third embodiment of the present invention.
FIG. 8B is a view illustrating a texture layer of a comparative example.
FIG. 9 is a view illustrating a texture layer of the third embodiment of the present invention.
FIG. 10 is a view illustrating a texture layer of the third embodiment of the present invention.

### DESCRIPTION OF THE PREFERRED EMBODIMENTS

### First Embodiment

Next, a solar cell and a solar cell manufacturing method of a first embodiment will be described with reference to drawings.

In these drawings which are utilized in the following explanation, appropriate changes have been made in the scale of the various members, in order to represent them at scales at which they can be easily understood.

### Solar Cell

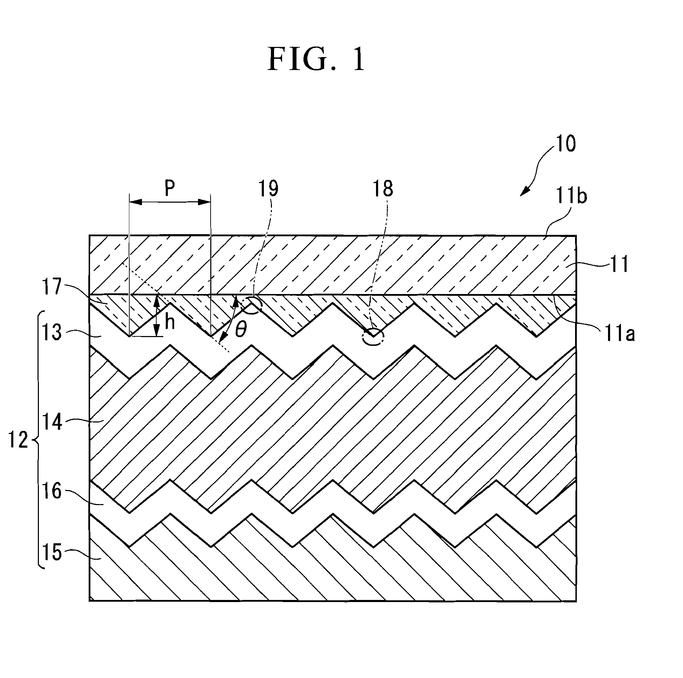

FIG. 1 is a cross-sectional view showing an amorphous silicon type solar cell.

As shown in FIG. 1, a solar cell 10 is a so-called single type solar cell and has a structure in which a photoelectric converter 12 is formed on one face 11a (first face, hereinafter, refer to back face 11a) of a transparent substrate 11 having insulation property.

Additionally, a texture layer 17 is disposed between the back face 11a and the photoelectric converter 12 as described below.

The substrate 11 is formed of an insulation material having a high level of sunlight transparency and durability such as a glass or a transparent resin.

In the solar cell 10, sunlight is incident to a side opposite to the back face 11a on which the photoelectric converter 12 is formed, that is, the other face 11b of the substrate 11 (second face, hereinafter, refer to top face 11b).

The photoelectric converter 12 has a structure in which a semiconductor layer 14 is between a top-face electrode 13 and a back face electrode 15, and is disposed over an entire area except for the periphery of the back face 11a of the substrate 11.

The top-face electrode 13 is made of metal oxidative product having optical transparency, and is formed so as to have the sheet resistance of 10 Ω/□ or more.

Specifically, it is preferable that the top-face electrode 13 be made of a material having a specific resistance of 200 µΩcm to 500 µΩcm and that the film thickness thereof be approximately from 0.2 µm to 0.5 µm.

If the film thickness of the top-face electrode 13 is formed so that the film thickness thereof is thinner than 0.2 µm, there is a concern that it is possible to ensure the conductivity of the top-face electrode 13, and it is thereby undesirable.

On the other hand, if the film thickness of the top-face electrode 13 is formed so that the film thickness thereof is thicker than 0.5 µm, there is a concern that the optical transmittance at the top-face electrode 13 decreases, and it is thereby undesirable.

In contrast, when the top-face electrode 13 is formed so that the film thickness thereof is from 0.2 µm to 0.5 µm, it is possible to improve the optical transmittance at the top-face electrode 13 n addition to ensuring the conductivity of the top-face electrode 13.

As the foregoing material of the top-face electrode 13 in the first embodiment, for example, SnO₂ is preferably used.

In other cases, as well as SnO₂, a so-called TCO (transparent conductive oxide) such as ITO (Indium Tin Oxide) or ZnO can be used.

The semiconductor layer 14 is provided on the top-face electrode 13.

The semiconductor layer 14 has a pin-junction structure in which, for example, an i-type amorphous silicon film (not shown in the figure) is sandwiched between a p-type amorphous silicon film (not shown in the figure) and an n-type amorphous silicon film (not shown in the figure).

In the semiconductor layer 14, the p-type amorphous silicon film, the i-type amorphous silicon film, and the n-type amorphous silicon film are stacked on the top-face electrode 13 in layers in this order.

When sunlight is incident to the semiconductor layer 14 and the i-type amorphous silicon film is illuminated with an energy particle that is included in sunlight, an electron and a hole are generated by the photovoltaic effect.

Then, the electron moves toward the n-type amorphous silicon film, and the hole moves toward the p-type amorphous silicon film.

The foregoing the electron and the hole are obtained from the top-face electrode 13 and the back-face electrode 15, respectively, it is thereby possible to convert optical energy into electrical energy (photoelectric conversion).

The back-face electrode 15 is disposed on a face of the semiconductor layer 14 opposite to the top-face electrode 13.

The back-face electrode 15 is formed of a conductive metal film such as Ag or Cu, and is formed by preferably using, for example, a low-temperature calcined nano-ink metal (Ag).

The back-face electrode 15 also has a function as a reflection layer that reflects sunlight passing through the semiconductor layer 14 and supplies the sunlight to the semiconductor layer 14 again.

Additionally, a transparent electrode 16 made of TCO or the like is provided between the back face electrode 15 and the semiconductor layer 14.

The transparent electrode 16 is an electrode for improving the barrier property between the back face electrode 15 and the semiconductor layer 14, the reflectance, or the like.

Here, the texture layer 17 is formed between the substrate 11 and the top-face electrode 13.

The texture layer 17 has an irregular configuration which is continuously formed at the position at which the texture layer 17 is in touch with the top-face electrode 13 and in a direction parallel to the substrate.

The texture layer 17 is a layer where a lot of protuberance portions 18 having a cone shape are continuously formed on the entire face on the back face 11a of the substrate 11. Recessed portions 19, which are surrounded by inclines of adjacent protuberance portions 18 and formed in a V-shape in the cross-section thereof, are formed between adjacent protuberance portions 18.

Therefore, a flat face which is parallel to the back face 11a of the substrate 11 does not exist in the texture layer 17.

In addition, the texture layer 17 is formed so that the distance P (pitch) between the protuberance portions 18 is, for example, approximately from 0.1 µm to 10 µm, and the height h from the back face 11a of the substrate 11 to the top portion of the protuberance portion 18 is, for example, approximately from 0.1 µm to 0.5 µm.

Moreover, in the texture layer 17, it is preferable that the angle between the face extending from the back face 11a to the protuberance portion and the back face 11a be, for example, 55°.

If the distance between the protuberance portions 18 and the height h of the protuberance portion 18 is less than 0.1 µm, a desired texture structure cannot be formed the top-face electrode 13 which is to be formed on the texture layer 17, and there is a concern that a prismatic effect or a light confining effect is not anticipated and it is thereby undesirable.

On the other hand, when the distance P between the protuberance portions 18 is greater than 10 µm and the protuberance portion 18 is formed so that the height h of the top portion thereof is greater than 0.5 µm, there is a concern that the optical transmittance of the texture layer 17 is degraded, and it is thereby undesirable.

In contrast, due to setting the distance P between the protuberance portions 18 and the height h thereof in the above-described range, it is possible to form a desired texture structure in the top-face electrode 13 in addition to maintaining the optical transmittance.

Additionally, as a constituent material of the texture layer 17, a transparent material having optical transparency in a visible light region is preferred, specifically, a material having the optical transmittance greater than or equal to 70% in the wavelength range of 400 to 1100 nm is preferred.

Moreover, when refractive indexes in a visible light region, of the substrate 11, the texture layer 17, and the top-face electrode 13 are defined as n0, n1, and n2, respectively, in addition, when a refractive index of the semiconductor layer 14 is defined as n3, it is preferable that n0 < n1 < n2 be satisfied.

With this configuration, since reflection of incidence light is suppressed at a boundary face between the substrate 11 and the texture layer 17 and between the texture layer 17 and the top-face electrode 13, it is possible to obtain a texture due to the top-face electrode 13 having a high degree of light confining effect with the thickness thereof being less than the conventional thickness, and it is possible to manufacture a solar cell 10 having a further high level of conversion efficiency.

In this case, when, for example, glass, a transparent resin, or the like is used for the substrate 11, it becomes n0≒1.4 to 1.5; when, for example, SnO₂, ITO, ZnO, TiO₂, or the like is used for the top-face electrode 13, it becomes n2≒1.9 to 2.5; additionally, when, for example, Si is used for the semiconductor layer 14, it becomes n3≒4; therefore, it is preferable that a refractive index of the texture layer 17 be set so that n1≒ 1.5 to 2.5 approximately.

As the foregoing material, a material in paste form such as SnO₂ (Silsesquioxanes or the like which is described below), a UV curable resin, thermosetting resin, or the like is preferably used.

In other cases, if the refractive indexes n0, n1, and n2 of three layers of the substrate 11, the texture layer 17, and the top-face electrode 13 are not completely equal to each other, n0 ≤ n1 < n2, n0 < n1 ≤ n2 may be satisfied.

Consequently, since each of the layers in the above-described photoelectric converter 12 (the top-face electrode 13, the semiconductor layer 14, the transparent electrode 16, and the back face electrode 15) is formed along the surface shape of the texture layer 17, an irregular configuration that is similar to the configuration of the recessed portions 18 and the protuberance portions 19 is continuously formed.

As a result, a solar cell 10 having a texture structure is finally formed.

In the foregoing solar cell 10, sunlight that was incident to the top face 11b of the substrate 11 refracts at the boundary face between the texture layer 17 and the top-face electrode 13, thereafter, passes through the top-face electrode 13, and is incident to the semiconductor layer 14.

Most sunlight that is incident to the semiconductor layer 14 refracts at the boundary face between the top-face electrode 13 and the semiconductor layer 14 and is introduced into the semiconductor layer 14.

Sunlight that was introduced into the semiconductor layer 14 is absorbed to the semiconductor layer 14, and the above-described photoelectric conversion is performed.

On the other hand, part of light that is incident to the semiconductor layer 14 reflects at the boundary face between the top-face electrode 13 and the semiconductor layer 14.

At this time, since the solar cell 10 of the first embodiment employs the texture structure, sunlight that was reflected at the boundary face between the top-face electrode 13 and the semiconductor layer 14 passes through the top-face electrode 13 and is again incident to the boundary face between the top-face electrode 13 and the semiconductor layer 14.

Consequently, the light that is again incident to the semiconductor layer 14 is further separated into sunlight that is introduced into the semiconductor layer 14 and sunlight that is reflected at the boundary face between the top-face electrode 13 and the semiconductor layer 14.

As mentioned above, due to the reflected sunlight that was not introduced into the semiconductor layer 14 being repeatedly reflected and incident between the top-face electrode 13 and the semiconductor layer 14, the sunlight is gradually introduced into the semiconductor layer 14.

As a result, it is possible to obtain a prismatic effect that the optical path of sunlight is extended and a light confining effect, and to increase the influx amount of light incident to the semiconductor layer 14.

### Solar Cell Manufacturing Method

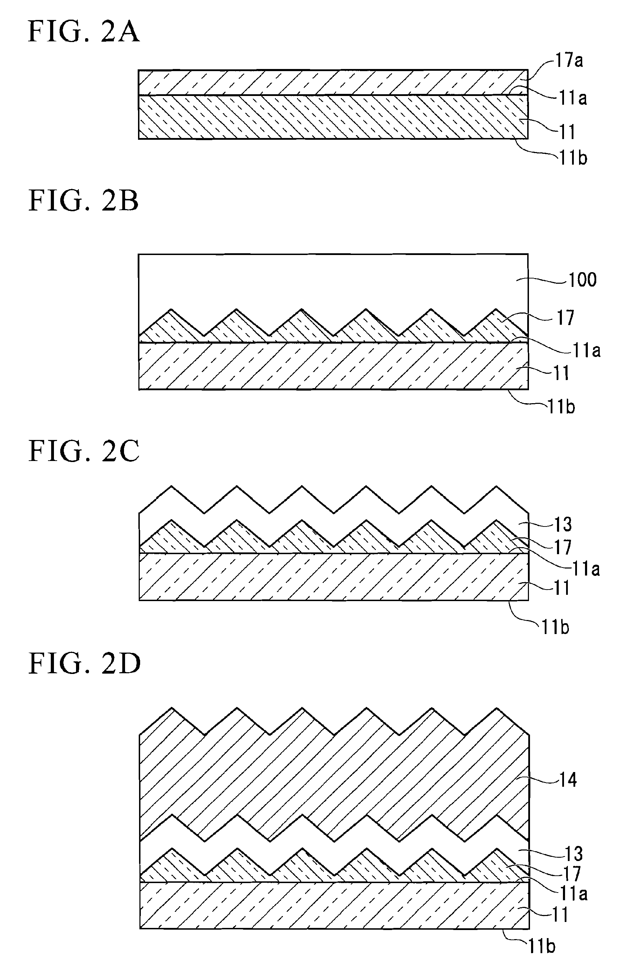

Next, a method for manufacturing the above-described solar cell will be described with reference to FIGS. 2A to 2D.

FIGS. 2A to 2D are flow sheets showing a solar cell manufacturing method.

First of all, as shown in FIG. 2A, a texture layer 17 (refer to FIG. 1) is formed on a back face 11a of a substrate 11 (texture layer formation step).

Firstly, a transparent material 17a (liquid material) that becomes a constituent material of the texture layer 17 is applied on the entire of face of the back face 11a of the substrate 11 using a spin coat method or the like.

As a constituent material of the texture layer 17, for example, a novel polymer material including silicon is used.

In the first embodiment, silsesquioxanes shown in Chemical Formula 1 is employed.

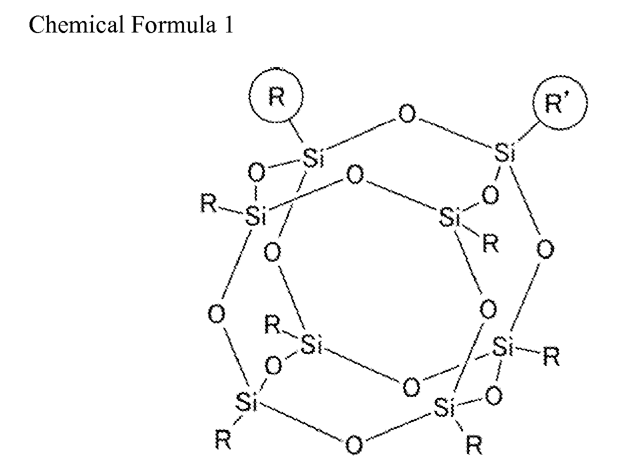

Subsequently, as shown in FIG. 2B, the substrate 11 is reversed so that the back face 11a on which the transparent material 17a is formed faces toward upside.

Thereafter, an irregularity is formed on the transparent material 17a (refer to FIG. 2A) which is applied on the back face 11a of the substrate 11.

In the first embodiment, the irregularity is formed on the transparent material 17a by use of a nanoimprint method.

A nanoimprint method is a method in which a negative pattern (pattern) which is referred to as a mold 100 formed using an electron beam exposure technique, an electroforming technique, and the like is prepared, the pattern of the mold 100 is transferred to the film forming material by stamping (pressing) a film forming material with the mold 100 so that the negative pattern is in contact with the transparent material 17a, and a lot of duplications thereof are thereby manufactured.

It is possible to perform microfabrication to the texture layer 17 using a nanoimprint method.

The mold 100 has an irregular pattern of the same size as that of the above-described texture layer 17 (refer to FIG. 1) on the surface of the mold 100.

Specifically, as a method for forming the mold 100, a method is adopted, in which, with respect to a glass substrate having a SnO₂ film on which irregular configuration having a size distributing in a predetermined range is formed by random interval, Ni is electrodeposited on the face of the above-described SnO₂ film with a film thickness of 300 µm using electroforming, the irregular configuration of the surface thereof is transferred and peeled, and a negative pattern 100 is obtained.

By stamping the transparent material 17a with the mold 100, the irregular pattern of the mold 100 is transferred to the transparent material 17a, and an irregularity is thereby formed on the transparent material 17a.

By using this method, the pattern (random pattern) of texture layer 17, which is preliminarily formed on the mold, can be transferred to the transparent material 17a formed on the back face 11a.

Thereafter, due to the transparent material 17a being cured, the texture layer 17 is formed.

In the above-described manner, by transferring the irregular pattern of the mold 100 to the transparent material 17a using a nanoimprint method, it is possible to easily form the texture layer 17 on the substrate 11 in a continuous manner.

Next, as shown in FIG. 2C, a top-face electrode 13 is formed on the texture layer 17 using a sputtering method, a CVD method, an arc plasma method, or the like.

Then, particles of film forming material of the top-face electrode 13 are deposited on the texture layer 17 along the surface shape thereof.

Because of this, the top-face electrode 13 having the irregularity which is the same configuration as the surface shape of the texture layer 17 is formed.

Consequently, as shown in FIG. 2D, after a semiconductor layer 14 is formed on the top-face electrode 13 using a CVD method or the like, a transparent electrode 16 and a back face electrode 15 are stacked in layers on the semiconductor layer 14 using a CVD method or the like.

As described above, it is possible to manufacture the solar cell 10 (refer to FIG. 1) having the above-described texture structure.

As mentioned above, the above-described solar cell of the first embodiment has the constitution in which the texture layer 17 made of a transparent material is formed between the substrate 11 and the top-face electrode 13.

Additionally, according to the above-described solar cell manufacturing method, after a texture layer 17 separated from the top-face electrode 13 is formed between the substrate 11 and the top-face electrode 13, the top-face electrode 13 is formed on the texture layer 17, and it is thereby possible to provide a configuration which copies the surface shape of the texture layer 17 (irregular configuration), on the surface of the top-face electrode 13.

Consequently, it is possible to manufacture a solar cell with the texture structure 10 having excellent prismatic effect that the optical path of sunlight is extended, light confining effect, or the like.

Because of this, unlike a conventional method, it is not necessary to form the top-face electrode so that the film thickness thereof is thick in order to form an irregular configuration on a top face of the top-face electrode.

Namely, since the top-face electrode 13 can be formed so that the film thickness thereof is thin, it is possible to improve the optical transmittance in the top-face electrode 13 and to increase the influx amount of sunlight incident to the semiconductor layer 14.

Therefore, the absorbed amount of sunlight in the semiconductor layer 14 increases, and it is possible to improve the conversion efficiency of the solar cell 10.

Additionally, by continuously forming irregularity on the substrate 11, it is possible to prevent a flat face from being formed on the top-face electrode 13 to be formed on the texture layer 17.

For this reason, since it is possible to obtain a prismatic effect that the optical path of sunlight is extended, a light confining effect, or the like at the entire of face of the substrate 11, and it is thereby possible to improve the conversion efficiency of a solar cell.

Moreover, since it is possible to eliminate the amount used of the top-face electrode 13 by forming the top-face electrode 13 so that the film thickness thereof is thin, it is possible to reduce the cost of manufacturing a solar cell 10 and it is also possible to improve the manufacturing efficiency.

Also, since the texture layer 17 is directly formed on the substrate 11 by use of a nanoimprint method, it is not necessary to form a high refractive index layer and a low refractive index layer unlike PCT International Publication No. WO 2005/27229, and the effect is thereby obtained that it is possible to reduce the cost of manufacturing a solar cell.

In addition, it is possible to adjust the protuberance portions 18 of the texture layer 17 and the irregular configuration including the recessed portions 19 by controlling transfer conditions in the nanoimprint method; since a preferred refractive index can be obtained, the texture layer can serve as a refractive index controlling layer.

Additionally, in the solar cell of the first embodiment, made of silsesquioxane, it is possible to form the texture layer 17 (texture layer made of SiO₂).

Furthermore, in the solar cell manufacturing method of the first embodiment, by applying a transparent material on the substrate and by pressing the mold having the pattern onto the transparent material applied on the substrate, the pattern is transferred to the transparent material, and an irregular configuration is thereby formed.

Because of this, by adequately selecting a pattern shape (for example, random pattern) formed on the mold, material type of the texture layer, or the like, it is possible to appropriately select a structure of the texture layer so as to obtain a desired conversion efficiency.

In other cases, a texture having a regular pattern can be formed by use of a mold having a regular or periodic pattern which is formed using an electron beam exposure technique or the like.

Furthermore, an amorphous silicon type solar cell is described in the above-described embodiment, but a microcrystalline silicon type solar cell or the like can also be adopted.

In addition, a single type solar cell is described in the above-described embodiment, but a tandem-type solar cell in which amorphous silicon and microcrystalline silicon are held between a pair of electrodes can also be adopted.

In the tandem-type solar cell, short-wavelength light is absorbed by a first semiconductor layer such as amorphous silicon and long-wavelength light is absorbed by a semiconductor layer such as microcrystalline silicon, and it is thereby possible to improve the conversion efficiency thereof.

Additionally, by providing an intermediate electrode between semiconductor layers, since part of light, which passed through the first semiconductor layer and reaches a second semiconductor layer, is reflected at the intermediate electrode and re-enters the first semiconductor layer, the sensitivity characteristics of the photoelectric converter is improved and the intermediate electrode contributes improvement of conversion efficiency.

### Experimental Examples

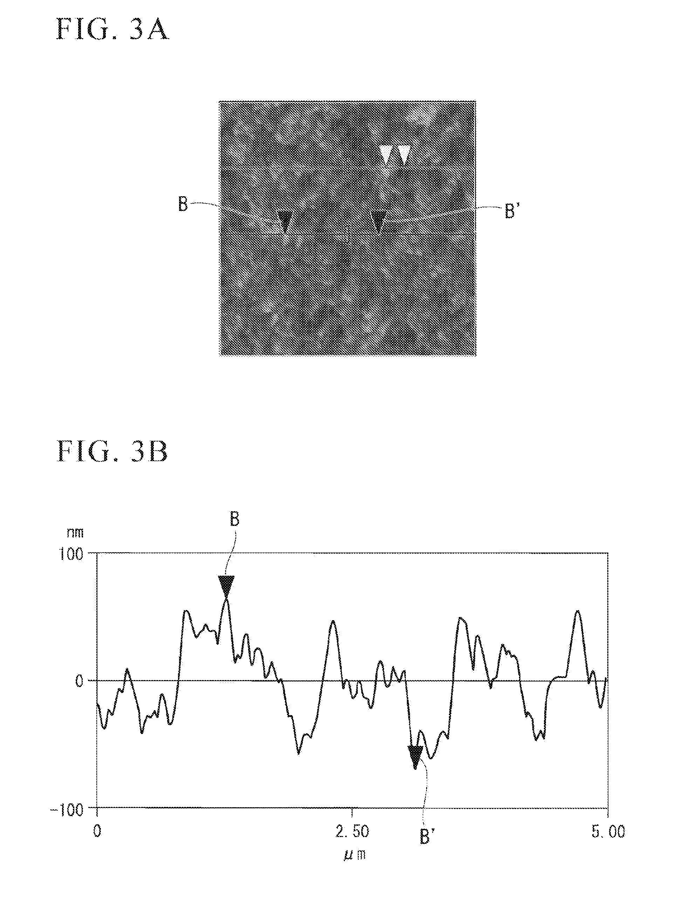

Next, Experimental Examples of the first embodiment will be specifically described with reference to FIGS. 3A to 3D.
FIG. 3A is an enlarged plan view illustrating the texture layer of the first embodiment, and showing observation of the texture layer 17 using AFM.
FIG. 3B is a view corresponding to FIG. 3A and showing a profile in a cross-sectional face.

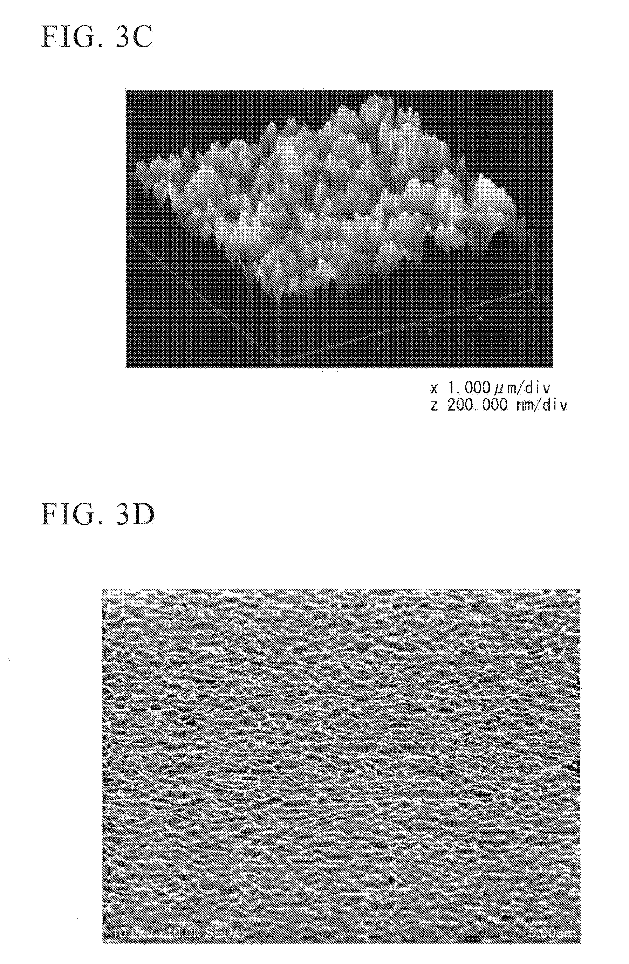

FIGS. 3C and 3D are enlarged perspective view illustrating the texture layer of the first embodiment, FIG. 3C shows observation using AFM, and FIG. 3D shows a SEM image of the texture layer 17.

Film thicknesses indicated by reference numeral B-B' in cross section of FIG. 3A are distributed as indicated by reference numerals B-B' in FIG. 3B.

Additionally, in FIGS. 3A and 3B, the axis of abscissas indicates the distance in the lateral direction with respect to the substrate 11.

Also, the axis of ordinate indicates the depth representing the irregular configuration formed in the texture layer 17.

L (horizontal distance between B and B') = 1.86 µm, RMS (Root-Mean-Square roughness) = 26.77 nm, Ra (Arithmetic Mean Deviation of the Profile, center line average roughness of protuberance portions) = 19.46 nm, Rmax (Maximum Height of roughness profile of the curve, maximum distance of protuberance portion from reference face) = 109.44 nm, and Rz (average height) = 55.56 nm were obtained in FIGS. 3A and 3B.

### Second Embodiment

Next, a solar cell and a solar cell manufacturing method of a second embodiment will be described with reference to drawings.

In the second embodiment, a structure or a method which is different from the above-described first embodiment will be described, and identical symbols are used for the elements which are identical to those of the first embodiment, and the explanations thereof are omitted or simplified.

The second embodiment is different from the first embodiment in terms of the method for forming the texture layer 17.

Specifically, the texture layer 17 is formed by use of an inkjet apparatus in the second embodiment.

### Inkjet Apparatus

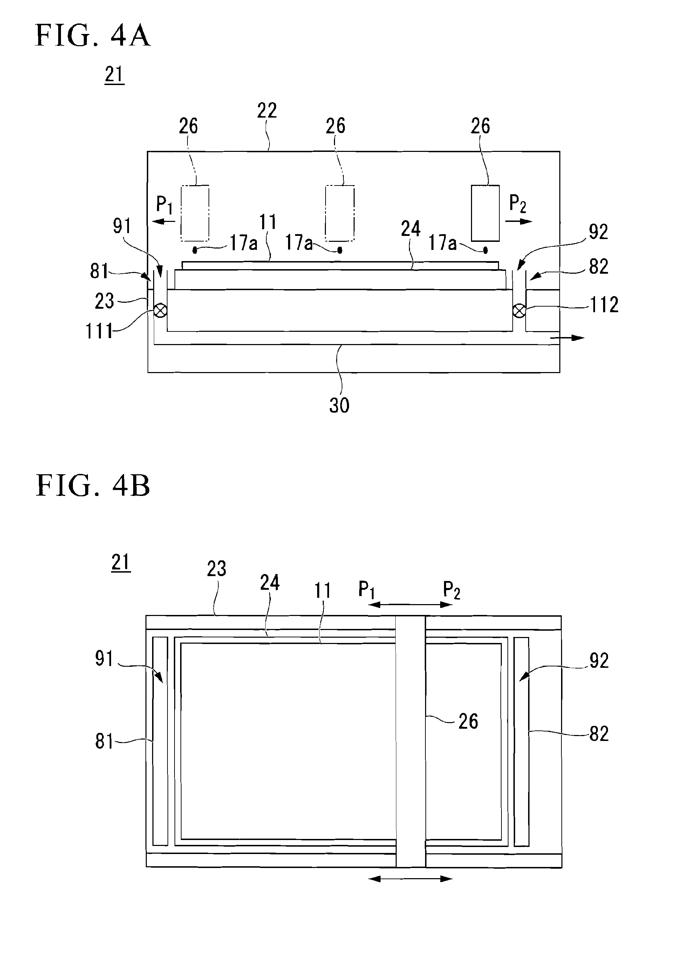

Firstly, the constitution of an inkjet apparatus will be described with reference to FIGS. 4A and 4B.
FIG. 4A is a cross-sectional view showing an inkjet apparatus which is used in a texture layer formation step of the second embodiment of the present invention.
FIG. 4B is a plan view showing an inkjet apparatus which is used in a texture layer formation step of the second embodiment of the present invention.

As shown in FIGS. 4A and 4B, the inkjet apparatus 21 of the embodiment is provided with a housing 22 into which external air is introduced through an into inlet port (not shown in the figure).

A main body 23 is provided inside of the housing 22, and a support table 24 is provided at an upper portion of the main body 23.

Consequently, for example, a substrate 11 is mounted on the support table 24.

An inkjet head 26 is provided above the support table 24 so as to face the support table 24.

As shown in FIG. 4B, the inkjet head 26 has the substantially same length of the width of the substrate 11 and has a plurality of nozzles for ej ecting a transparent material 17a onto the substrate 11.

Additionally, the inkjet head 26 is configured to linearly move in the direction indicated by the arrow P1 or the arrow P2 while ejecting the transparent material 17a onto the substrate 11.

In the second embodiment, the direction of arrow P1 represents a first direction, and the direction of arrow P2 represents a second direction.

A first vacuuming section 81 that is formed of a tube-shaped member is provided in the housing 22.

The first vacuuming section 81 is connected to a vacuum unit (not shown in the figure) via a vacuuming pipe 30 and is configured to discharge an atmosphere of the housing 22 to outside thereof via a first vacuuming port 91 which is provided at an upper end portion of the first vacuuming section 81.

A first openable valve 111 is provided at the first vacuuming section 81.

Opening and closing operations of the first openable valve 111 are controlled in accordance with the moving direction of the inkjet head 26.

A second vacuuming section 82 that is formed of a tube-shaped member is provided in the housing 22.

The second vacuuming section 82 has the same constitution as the first vacuuming section 81, is connected to a vacuum unit that is not shown in the figure via a vacuuming pipe 30, and is configured to discharge an atmosphere of the housing 22 to outside thereof via a second vacuuming port 92 which is provided at an upper end portion of the second vacuuming section 82.

A second openable valve 112 is provided at the second vacuuming section 82.

Opening and closing operations of the second openable valve 112 are controlled in accordance with the moving direction of the inkjet head 26.

Next, a method for forming the texture layer 17 by use of the inkjet apparatus shown in FIGS. 4A and 4B (hereinafter, inkjet method) will be described.

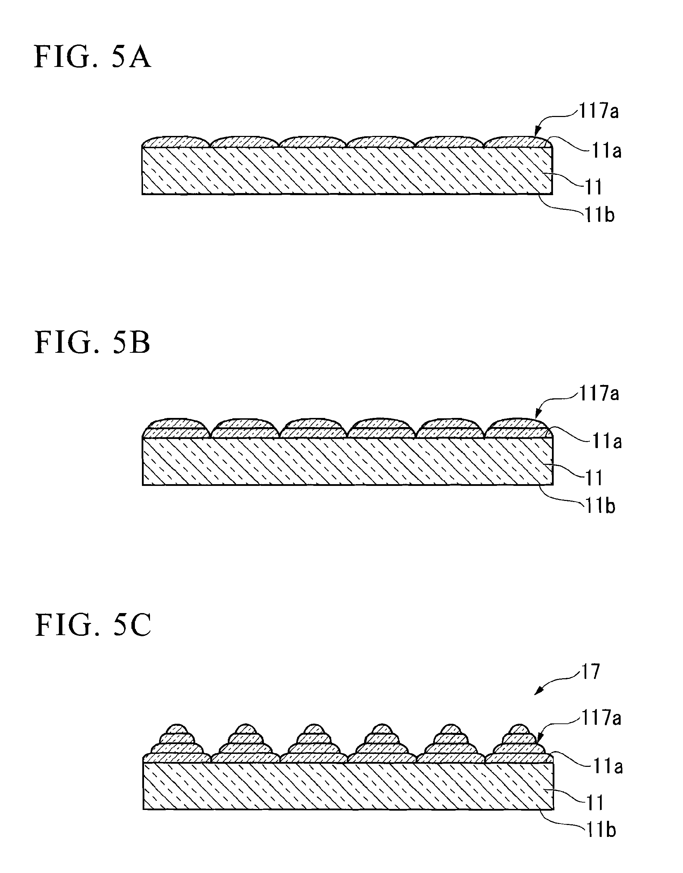

FIGS. 5A to 5C is a flow sheet showing the texture layer formation step of the second embodiment and is a view showing a step of forming the texture layer.

Firstly, as shown in FIG. 5A, on a back face 11a of a substrate 11, droplets of a transparent material are thinly applied on a region on which protuberance portions 18 (refer to FIG. 1) is to be formed, and the droplets are cured.

The droplet 117a made of the transparent material has a substantially hemispherical shape (configuration having curvature).

In a case of applying a transparent material, the inkjet head 26 linearly moves in the direction indicated by the arrow P1 or the arrow P2 while ejecting the transparent material on the substrate 11, therefore, the transparent material is applied on the back face 11a of the substrate 11.

Additionally, by controlling the position of the inkjet head 26 and the timing of ejection of the transparent material by the inkjet head 26, the droplet 117a is ejected onto a predetermined position.

Because of this, the pitch between a plurality of droplets 117a is desirably determined.

Furthermore, after the droplets 117a are applied, the droplets 117a are cured by a drying-curing treatment.

Subsequently, as shown in FIGS. 5B and 5C, the applying and curing of the transparent material is repeated in multiple times on the region on which the protuberance portions 18 is to be formed, and the layered body in which a plurality of transparent materials is stacked is formed.

At this time, the ejection rate of the transparent material to be formed on the substrate 11a in a second step is less than the ejection rate of the transparent material formed in a first (initial) step.

Furthermore, the transparent material is ejected such that the ejection rate of the transparent material to be formed in a third step is less than the ejection rate of the transparent material formed in the second step.

In the above-described manner, by stacking the transparent material in layers such that the ejection rate gradually decreases, the layered body of the transparent material is formed such that the layered body gradually become fine toward the end thereof.

For this reason, it is possible to continuously form the texture layer 17 whose peripheral face is curved on the back face 11a of the substrate 11.

In other cases, if the layered body of the transparent material is molten by melting the cured transparent material, it is also possible to form a texture layer having an irregularity of a smooth curve.

In the foregoing second embodiment, since droplets are ejected based on ejection data used for driving the inkjet apparatus, it is possible to form the texture layer 17 having an irregular pattern in which an irregular configuration is regularly arrayed.

Also, since the texture layer 17 is directly formed on the substrate 11 by use of an inkjet apparatus, it is not necessary to form a high refractive index layer and a low refractive index layer unlike PCT International Publication No. WO 2005/27229, and the effect is thereby obtained that it is possible to reduce the cost of manufacturing a solar cell.

Additionally, since it is possible to adjust the irregular configuration including the protuberance portions and the recessed portions of the texture layer 17 by controlling a droplet ejection condition used for an inkjet apparatus, and it is possible to obtain a preferred refractive index, the texture layer can serve as a refractive index controlling layer.

If the relative position between the inkjet head 26 and the substrate is randomly controlled, it is possible to form the texture layer 17 having a random pattern.

In addition, in the solar cell manufacturing method of the second embodiment, the transparent material is applied by use of an inkjet apparatus, and a continuous irregular configuration is formed.

For this reason, by adequately selecting the ejection rate of a droplet made of the transparent material, the position at which the droplet is disposed on the substrate, material type of the texture layer or the like, it is possible to appropriately select a structure of the texture layer so as to obtain a desired conversion efficiency.

Modified Example of Second Embodiment

Next, an inkjet method of a modified example used for forming the texture layer 17 will be described.

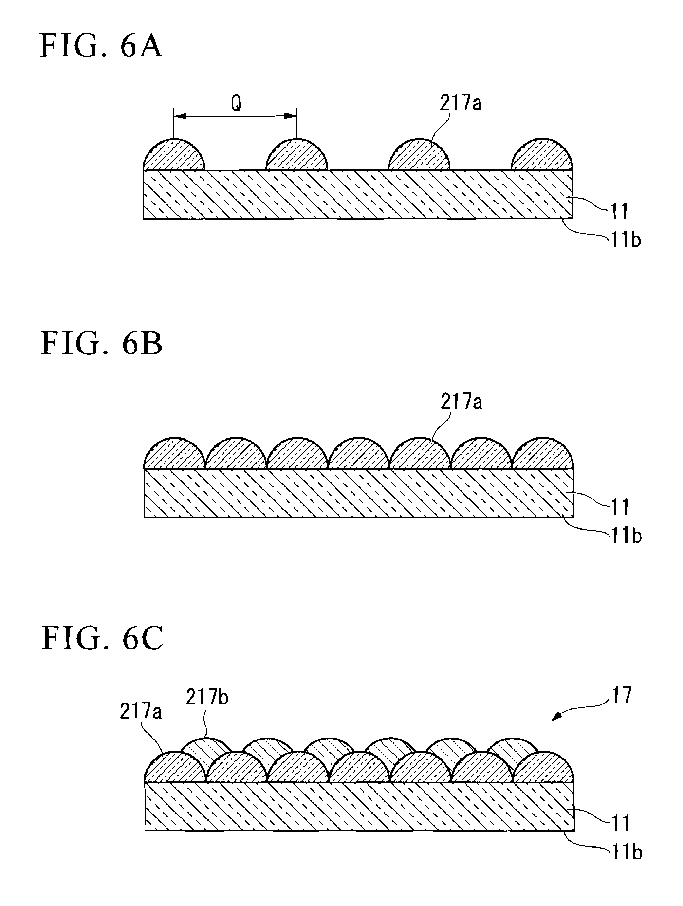

FIGS. 6A to 6C are views showing an inkjet method of a modified example and are plan views illustrating a texture layer formation step using an inkjet method.

In the modified example of the second embodiment, identical symbols are used for the elements which are identical to those of the second embodiment, and the explanations thereof are omitted or simplified.

At first, as shown in FIG. 6A, in a first process, a plurality of droplets 217a (first droplet) made of a transparent material is ejected onto the back face 11b of the substrate 11 so as to be arranged separately from each other by a pitch Q.

Thereafter, the droplets 217a is cured by the drying-curing treatment.

Here, the size of the pitch Q is a value such that distance between the droplets adjacent to each other is the same as the diameter of the droplet.

Next, as shown in FIG. 6B, in a second process, droplets 217a (second droplet) are ejected between the droplets 271a that were separated by the pitch Q, and the droplets 217a are cured by the drying-curing treatment.

In other words, after the droplets 217a that are the first droplets is formed, the droplets 217a that are the second droplets are ejected on the exposed substrate 11.

Furthermore, as shown in FIG. 6C, in a third process, droplets 217b (third droplet) are ejected between the plurality of the droplets 217a that were formed on the back face 11b of the substrate 11 so as to overlap the plurality of droplets 217a, and the droplets 217b are cured by the drying-curing treatment.

In the processes shown in the foregoing FIGS. 6A to 6C, the ejection rates of the droplets 217a and 217b are constant.

Because of this, even the case where a layered body is not formed as shown in FIGS. 5A to 5C, it is possible to form a continuous the texture layer 17 having an irregular configuration on the back face 11b of the substrate 11.

Additionally, since the drying-curing treatment is performed in each of the first process, the second process, and the third process, it is possible to prevent adjacent droplets that are not cured from being mutually combined.

For this reason, it is possible to prevent leveling action (the surface of the layer formed by applying droplets is planarized) of the texture layer 17, which is caused by the plurality of droplets being mutually combined.

The second embodiment and the modified example are described above, but the conditions of manufacture for using the above-described inkjet method are adequately set.

For example, a shape of the droplet that is ejected on the back face 11a of the substrate 11 or the angle of contact between the back face 11a and the droplet may be appropriately controlled.

In this case, a desired droplet shape or a desired angle of contact is obtained by rinsing out the back face 11a of the substrate 11 using a predetermined cleaning liquid, by performing a liquid-repellency imparting process to the back face 11a, or by performing a liquid-affinity imparting process.

In addition, the droplets are ejected such that a transparent material is disposed on the entire of the exposed face of the substrate 11 in FIG. 6B, but the droplets may be ejected so as to cause the substrate 11 to be exposed.

### Third Embodiment

Next, a solar cell and a solar cell manufacturing method of a third embodiment will be described with reference to drawings.

In the third embodiment, a structure or a method which is different from the above-described first and second embodiments will be described, and identical symbols are used for the elements which are identical to those of the first embodiment, and the explanations thereof are omitted or simplified.

The third embodiment is different from the above-described first and second embodiments in terms of the method for forming the texture layer 17.

Specifically, the texture layer 17 is formed by use of a spraying method in the third embodiment.

Hereinafter, a method for forming a texture layer 17 using a spray is referred to as a spraying method.

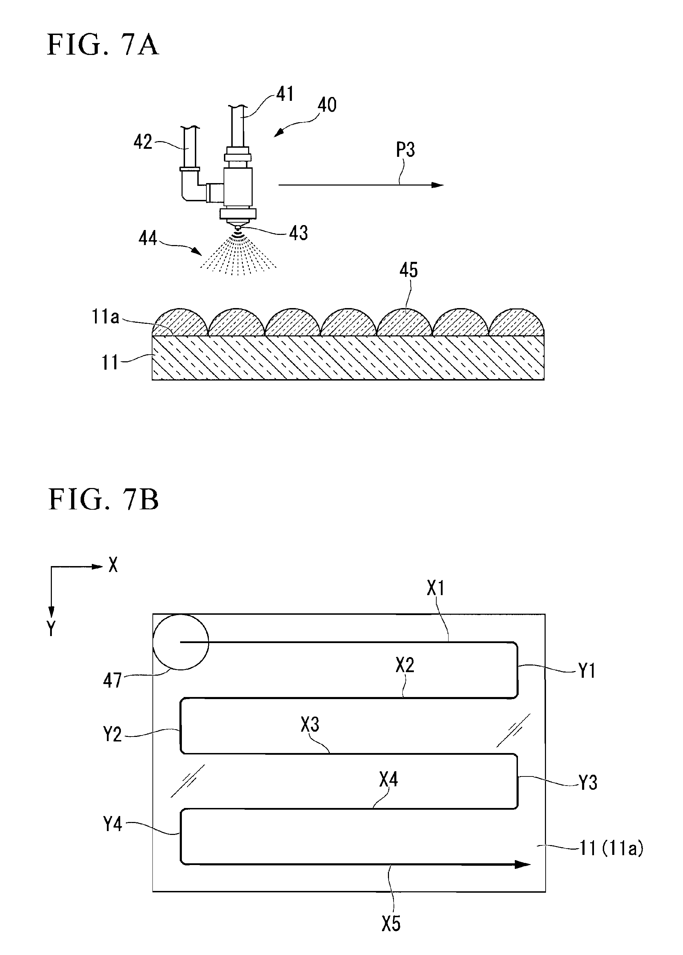

Firstly, with reference to FIGS. 7A and 7B, a spraying method will be described.
FIG. 7A is a side view illustrating a texture layer formation step using a spraying method.
FIG. 7B is a plan view illustrating a texture layer formation step using a spraying method.

As shown in FIG. 7A, in the spraying method of third embodiment, a liquid spray head 40 which blends a liquid with a gas and sprays a transparent material (transparent liquid material) onto a substrate 11 is used.

As the foregoing liquid spray head 40, for example, two-fluid nozzle (produced by ATOMAX Co,.ltd) is adopted.

A material supply pipe 41 and a gas supply pipe 42 is connected to the liquid spray head 40.

Additionally, the liquid spray head 40 has a nozzle 43 spraying a material.

A raw material that is a constituent material of the texture layer 17 is supplied to the liquid spray head 40 through the material supply pipe 41.

A gas which is used for spraying the constituent material of the texture layer 17 is supplied to the liquid spray head 40 through the gas supply pipe 42.

The constituent material of the texture layer 17 and the gas are mixed in the liquid spray head 40, pass through the nozzle 43, and are sprayed toward the back face 11a of the substrate 11 (reference numeral 44).

The transparent material which is supplied through the material supply pipe 41 contains the constituent material of the texture layer 17 and a solvent.

As the constituent material of the texture layer 17, silsesquioxane may be used as described above, or a known transparent material or the like may be used.

In the embodiment, HSQ (Hydrogen Silsesquioxane: trade name is FOX-16 produced by Dow Coming) is used.

Additionally, as a solvent, a solvent having a low boiling point is used.

Furthermore, as the gas supplied through the gas supply pipe 42, air or nitrogen is used.

Moreover, in the liquid spray head 40, it is possible to control the particle diameter of the microscopic droplet sprayed from the nozzle 43.

Consequently, the liquid spray head 40 is adjusted so as to obtain an optimal droplet diameter for forming the texture layer 17.

Additionally, in the third embodiment, the distance between the liquid spray head 40 and the substrate 11 is 30 to 50 mm, the liquid spray head 40 is disposed so as to face the back face 11a of the substrate 11.

Moreover, as an atmosphere in which the spraying method is performed, a temperature is a room temperature in the third embodiment.

In addition, in FIG. 7A, the distance between the liquid spray head 40 and the substrate 11 is maintained, the transparent material is sprayed from the liquid spray head 40 while the liquid spray head 40 is moved relatively to the substrate 11 (reference numeral P3) in the direction parallel to the substrate 11.

Because of this, in a state where the liquid spray head 40 is separated from the substrate 11 by a predetermined distance, the transparent material 44 is sprayed onto the back face 11a of the substrate 11.

For this reason, a plurality of microscopic droplets 45 having a substantially hemispherical shape (configuration having curvature) are formed on the back face 11a of the substrate 11.

Additionally, the plurality of microscopic droplets 45 is applied on the substrate 11 so as to have a random pattern.

In addition, in FIG. 7A, the plurality of microscopic droplets 45 are adjacent to each other while the back face 11a of the substrate 11 is not exposed, but the plurality of microscopic droplets 45 are sprayed onto the back face 11a such that the back face 11a is partially exposed as a practical matter.

After the transparent material 44 is sprayed and the microscopic droplets 45 are formed on the back face 11a of the substrate 11 in the above-described manner, the microscopic droplets 45 are dried and cured.

As a drying method and a curing method, a method for irradiating a transparent material with ultraviolet light or a method for heating a transparent material is employed depending on transparent material types (UV curable resin, thermosetting resin).

In the third embodiment, the liquid spray head 40 moves relatively to the substrate 11 in the X-axial direction and the Y-axial direction shown in FIG. 7B.

The substrate 11 may move with the liquid spray head 40 being fixed, and the liquid spray head 40 may move with the substrate 11 being fixed.

In FIG. 7B, reference numeral 47 represents a spraying region onto which the transparent material 44 ejected from the liquid spray head 40 is to be sprayed on the substrate 11 (back face 11a).

Additionally, reference numerals X1 to X5 and reference numerals Y1 to Y4 represent a pathway in which the spraying region 47 moves on the substrate 11.

In an example shown in FIG. 7B, the spraying region 47 firstly moves in accordance with a scanning direction X1 on the back face 11a of the substrate 11, thereafter, the spraying region 47 moves in accordance with a scanning direction Y1 on the back face 11a of the substrate 11.

Subsequently, the spraying region 47 moves in accordance with a scanning direction X2 opposite to the scanning direction X1 on the back face 11a of the substrate 11, thereafter, the spraying region 47 moves in accordance with a scanning direction Y2 on the substrate 11.

Hereinafter, in the same manner as described above, the spraying region 47 moves along scanning directions X3, Y3, X4, Y4, and X5 in order.

For this reason, the spraying region 47 scans the entire of the back face 11a of the substrate 11, a transparent material is sprayed onto the entire of the back face 11a of the substrate 11.

Additionally, after the transparent material is sprayed, a drying treatment and a curing treatment are performed.

By using the above-described spraying method, it is possible to form, on the back face 11a, the texture layer 17 having a continuous irregular configuration in the direction parallel to the back face 11a.

Also, since the texture layer 17 is directly formed on the substrate 11 by use of a spraying method, it is not necessary to form a high refractive index layer and a low refractive index layer unlike PCT International Publication No. WO 2005/27229, and the effect is thereby obtained that it is possible to reduce the cost of manufacturing a solar cell.

In addition, it is possible to adjust the protuberance portions of the texture layer 17 and the irregular configuration including the recessed portions by controlling the conditions for spraying the droplets in the spraying method; since a preferred refractive index can be obtained, the texture layer can serve as a refractive index controlling layer.

In the solar cell manufacturing method of the third embodiment, a transparent material is sprayed by use of a spraying method, and the texture layer having an irregular configuration is formed.

Because of this, by adequately selecting a diameter of the droplet to be sprayed, the distance between a liquid spray head and a substrate, material type of the texture layer, or the like, it is possible to appropriately select a structure of the texture layer so as to obtain a desired conversion efficiency.

First Modified Example of Third Embodiment

Next, a spraying method of a first modified example used for forming the texture layer 17 will be described.

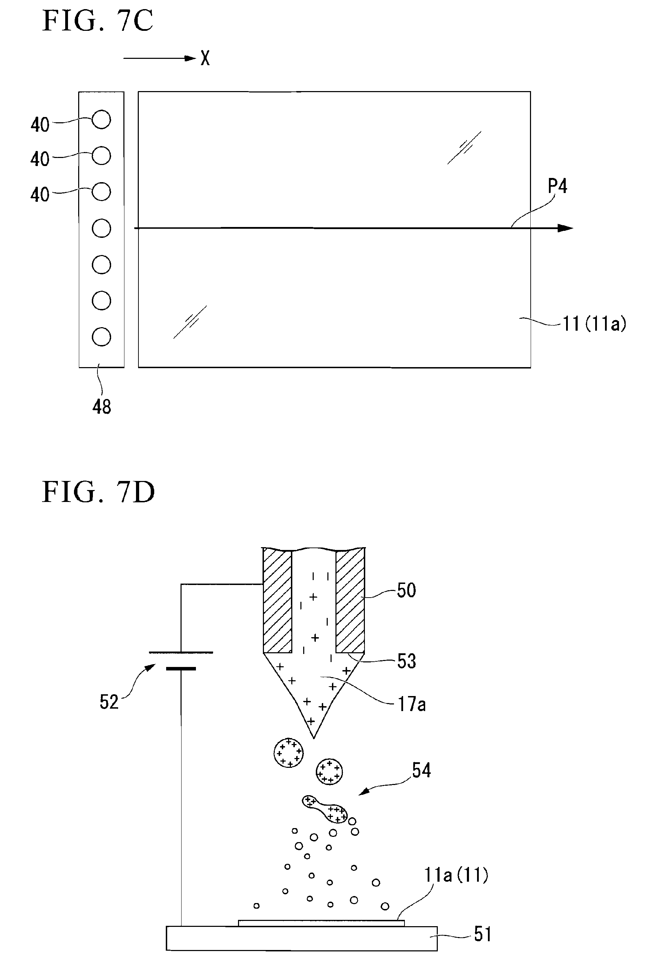

FIG. 7C is a view showing a first modified example of a spraying method and is a plan view illustrating a texture layer formation step using the spraying method.

In the first modified example of the third embodiment, identical symbols are used for the elements which are identical to those of the third embodiment, and the explanations thereof are omitted or simplified.

In the above-described spraying method shown in FIG. 7B, a transparent material is sprayed onto the back face 11a of the substrate 11 by scanning the face with the spraying region 47 served by the liquid spray head 40 in accordance with the scanning directions X1 to X5 and Y1 to Y4.

In contrast, in FIG. 7C, a transparent material is sprayed onto the back face 11a of the substrate 11 by use of a spray line head 48 in which a plurality of liquid spray heads 40 is linearly arranged.

Specifically, a transparent material is sprayed as shown in FIG. 7A while moving the spray line head 48 relatively to the substrate 11 in a direction P4 which coincides with the X-axial direction shown in FIG. 7C.

The substrate 11 may move with the spray line head 48 being fixed, and the spray line head 48 may move with the substrate 11 being fixed.

According to the method for using the foregoing spray line head 48, since it is not necessary to move the spraying region 47 of the liquid spray head 40 along the X-axial direction and the Y-axial direction a plurality of times, generation of a mottled applied pattern which is caused by partially superimposed spraying regions 47 is prevented, and it is possible to form a texture layer 17 which does not have a mottle.

### Second Modified Example of Third Embodiment

Next, a spraying method of a second modified example used for forming the texture layer 17 will be described.

FIG. 7D is a view showing a second modified example of a spraying method and is a plan view illustrating a texture layer formation step using the spraying method.

In the second modified example of the third embodiment, identical symbols are used for the elements which are identical to those of the third embodiment, and the explanations thereof are omitted or simplified.

In the above-described spraying method shown in FIG. 7A, a constituent material of the texture layer 17 and a solvent are sprayed on the substrate 11 by use of the liquid spray head 40.

In contrast, FIG. 7D, a constituent material of the texture layer 17 and a solvent are sprayed on the substrate 11 by use of an electro-spray deposition method (ESD method) using an electrostatic spray.

As shown in FIG. 7D, in the ESD method, an electrostatic spray head 50 is electrically connected to a counter electrode 51 with a high-voltage DC power supply 52 interposed therebetween.

Additionally, the substrate 11 is mounted on the counter electrode 51.

Furthermore, a voltage supplied from the high-voltage DC power supply 52 and between the electrostatic spray head 50 and the counter electrode 51 is, for example, 6 to 8 kV, and an electrical current is, for example, 10 to 20µA.

In addition, the amount of the transparent material 17a that is pushed out from the electrostatic spray head 50 is, for example, 5 µL/min.

Moreover, the distance between a nozzle 53 and the substrate 11 is 30 to 50 mm.

Also, as a material of the transparent material 17a, the material described in the above-described third embodiment is used.

With this configuration, the transparent material 17a filling up the electrostatic spray head 50 is electrostatically charged with a positive electrical charge.

Consequently, by pushing out the transparent material 17a in the electrostatic spray head 50 toward the substrate 11, the transparent material 17a is exposed from the nozzle 53 of the electrostatic spray head 50.

Due to the action of static electricity which is generated by the voltage supplied between the electrostatic spray head 50 and the counter electrode 51, the transparent material 17a is finely scattered and sprayed toward the substrate 11.

Additionally, between the electrostatic spray head 50 and the substrate 11, the particles of the transparent material 54 in flight are further finely scattered by the action of static electricity, and applied onto the back face 11a of the substrate 11.

Moreover, as a method for moving the substrate 11 relatively to the electrostatic spray head 50, a scanning method using the electrostatic spray head 50 as shown in FIG. 7B, or a method using the linearly-arranged electrostatic spray head 50 as shown in FIG. 7C is adopted.

In the ESD method using the foregoing electrostatic spray head 50, the transparent material 17a is electrostatically charged by a high-voltage power that is supplied from the high-voltage DC power supply 52, microscopic droplets made of the transparent material 17a are generated by the action of static electricity and can be applied on the substrate 11.

Therefore, by using the ESD method, it is possible to form, on the back face 11a, the texture layer 17 having a continuous irregular configuration in the direction parallel to the back face 11a.

The third embodiment (including the first modified example and the second modified example) are described above, but the conditions of forming for a texture layer 17 using the above-described spraying method and ESD method are adequately set.

By using, for example, a temperature controlling stage for controlling a temperature of the substrate, the texture layer 17 may be formed by spraying a transparent material using a spraying method in a state where a temperature of the substrate disposed on the temperature controlling stage is managed.

In this case, it is possible to desirably control the evaporating rate of the solvent contained in the transparent material sprayed onto substrate, the diameter of the transparent material sprayed onto the substrate, or the like.

Additionally, the region onto which the transparent material sprayed from the nozzle is applied or the flight duration of the transparent material may be controlled by setting up the distance between a nozzle and a substrate to be a predetermined distance.

In this case, due to the nozzle approaching the substrate, the flight duration of the transparent material decreases, the drying time thereof shortens, and it is thereby possible to spray the transparent material onto the substrate in a state where the viscous property of the transparent material is low.

Alternatively, by distancing the nozzle from the substrate, the flight duration of the transparent material increases, the drying time thereof lengthens, the solvent is evaporated from the transparent material at some level, and it is possible to spray the transparent material onto the substrate in a state where the viscous property of the transparent material is high.

Furthermore, a shape of droplet that is sprayed onto the back face 11a of the substrate 11 or the contact between the back face 11a and the droplet may be adequately controlled.

In this case, a desired droplet shape or a desired angle of contact is obtained by rinsing out the back face 11a of the substrate 11 using a predetermined cleaning liquid, by performing a liquid-repellency imparting process to the back face 11a, or by performing a liquid-affinity imparting process.

In addition, as the transparent material supplied through the material supply pipe 41, a solvent type maybe appropriately selected and the contained amount of the solvent may be desirably set.

Additionally, in an atmosphere in which a spraying method is performed, the temperature is appropriately set in view of the drying rate of a transparent material (containing a constituent material of the texture layer 17 and a solvent) or the like.

Furthermore, a spray process may be separated into a plurality of steps.

In this case, by a first step of spraying, a first layer of the texture layer 17 is formed on the back face 11a.

By a second step of spraying, a second layer of the texture layer 17 is formed on the back face 11a and the first layer of the texture layer 17.

By repeating the foregoing spraying operation in plurality times, a texture layer 17 that is constituted of a plurality of layer may be obtained.

### Experimental Examples

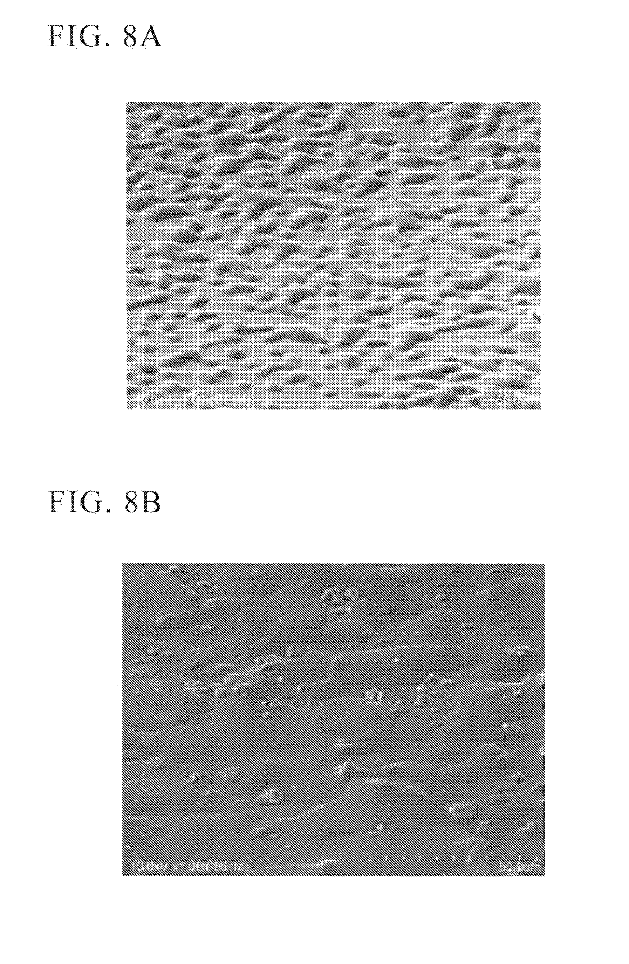

Next, Experimental Examples of the third embodiment will be specifically described with reference to FIGS. 8A, 8B, 9, and 10.
FIG. 8A shows a SEM image of the texture layer formed using the spraying method of the present invention.
FIG. 8B is a SEM image representing as a comparative example of a texture layer.

The texture layer shown in FIG. 8A was obtained by use of the ESD method shown in FIG. 7D.

The distance between the substrate 11 and the nozzle 53 was 50 mm, an applied voltage supplied to the high-voltage DC power supply 52 was 6.5 kV. Moreover, the droplet diameter was 3 µm.

On the other hand, the texture layer shown in FIG. 8B was obtained by use of a commonly-used two-fluid nozzle. The distance between the substrate 11 and the nozzle was 50 mm. Additionally, the droplet diameter was 10 µm.

Additionally, in FIGS. 8A and 8B, as a transparent material, HSQ (Hydrogen Silsequioxane: trade name is FOX-16 produced by Dow Coming) was used.

Furthermore, all of a substrate temperature, a temperature in an atmosphere, and the temperature of the nozzle was a room temperature (24°). Additionally, the relative humidity was 45%RH.

In the present invention shown in FIG. 8A, microscopic droplets were randomly distributed.

Because of this, a texture layer having an irregular configuration and a random pattern were formed on the substrate.

In contrast, in a comparative example shown in FIG. 8B, adjacent droplets was mutually combined, and a leveled film was generated.

As evidenced by FIGS. 8A and 8B, it was seen that, even where the conditions of the transparent material and the distance between the substrate and the nozzle of FIG. 8A are the same as that of FIGS. 8B, leveling action occurs in the case of FIG. 8B in which a droplet diameter was 10 µm, and leveling action does not occur in the case of FIG. 8A in which a droplet diameter was 3 µm.

In other cases, FIG. 8A shows a case of using a ESD method, but even where a texture layer is formed by use of a spraying method shown in FIG. 7A while a droplet diameter is 3 µm, since droplet diameters are distributed, a texture layer having an irregular configuration in which microscopic droplets are randomly distributed is obtained in a similar way as in FIG. 8A.

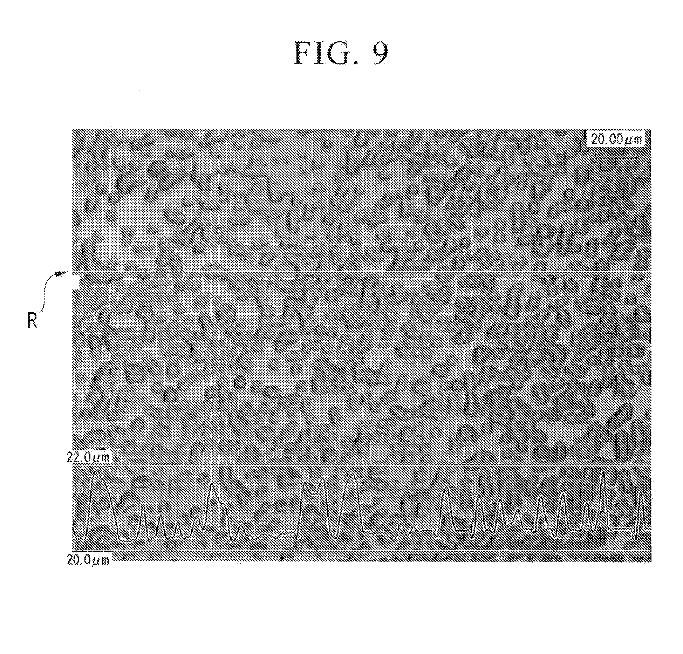

FIG. 9 is a plan view obtained by capturing the texture layer which was formed using the spraying method of the present invention and is a view showing the film thickness distribution of a texture layer.

In FIG. 9 shows a measurement result of a film thickness at a cross section represented by reference numeral R.

Here, in FIG. 9, "20 µm" represented by the axis of abscissas indicates a thickness of the substrate 11 and the texture layer at the portion represented by reference numeral R.

Additionally, total film thickness of the substrate 11 and the texture layer is distributed in the range of 20 µm to 22 µm, that is, it is seen that a film thickness of the texture layer is less than or equal to 2.0 µm.

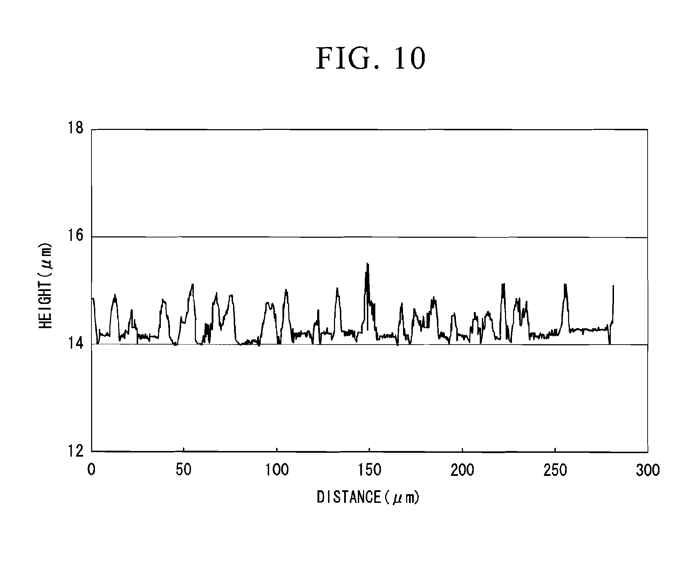

FIG. 10 is a view showing a surface roughness of a texture layer which was obtained by use of the spraying method of the present invention.
FIG. 10 shows an example in which a texture layer was formed on the substrate 11 having a thickness of 14 µm.

As shown in FIG. 10, it was determined that the film thickness of the texture layer is 2.0 µm.

Additionally, the Ra (center line average roughness of protuberance portions) was 0.23 µm, the Ry was 1.88 µm, the Rz (average height) was 1.57 µm, the Sm was 8.12 µm, and the S was 1.29 µm.

That is, a distance between the top portions of the texture layer of less than or equal to 10 µm was obtained.

Consequently, it was seen that the distance between the top portions adjacent to each other is from 0.1 µm to 10 µm in the texture layer.

In addition, the technical scope of the invention is not limited to the above embodiments, but includes a constitution in which various modifications may be added to the above-described embodiments without departing from the scope of the invention.

That is, the constitutions or the like of the above-described embodiment are an example and can be appropriately modified.

### Industrial Applicability

As described above in detail, the present invention is applicable to a solar cell manufacturing method and a solar cell having a texture structure, where it is possible to achieve an improved optical transmittance.

## Claims

1. A solar cell comprising:
a photoelectric converter in which a first electrode layer, a photoelectric conversion layer, and a second electrode layer are stacked on a substrate in order; and
a texture layer that is disposed between the substrate and the first electrode layer, made of a transparent material in a visible light region, and has a continuous irregular configuration on a face that is in touch with the first electrode layer.

2. The solar cell according to claim 1, wherein
when refractive indexes in a visible light region, of the substrate, the texture layer, and the first electrode layer are defined as n0, n1, and n2, respectively, n0 < n1 < n2 is satisfied.

3. The solar cell according to claim 1 or claim 2, wherein
a distance between top portions adjacent to each other in the texture layer is from 0.1 µm to 10 µm, and a film thickness of the first electrode layer is from 0.2 µm to 0.5 µm.

4. A solar cell manufacturing method, the solar cell having a photoelectric converter in which a first electrode layer, a photoelectric conversion layer, and a second electrode layer are stacked on a substrate in order, the method comprising:
a step of forming a texture layer forming a continuous irregular configuration on the substrate by use of a transparent material in a visible light region before forming the first electrode layer, wherein
the forming of the texture layer includes:
a step of applying the transparent material on the substrate; and
a step of forming an irregular configuration by pressing a mold having a pattern onto the transparent material applied on the substrate such that the pattern is transferred to the transparent material.

5. A solar cell manufacturing method, the solar cell having a photoelectric converter in which a first electrode layer, a photoelectric conversion layer, and a second electrode layer are stacked on a substrate in order, the method comprising:
a step of forming a texture layer forming a continuous irregular configuration on the substrate by use of a transparent material in a visible light region before forming the first electrode layer, wherein
the forming of the texture layer includes forming a continuous irregular configuration by applying the transparent material on the substrate using an inkjet apparatus.

6. A solar cell manufacturing method, the solar cell having a photoelectric converter in which a first electrode layer, a photoelectric conversion layer, and a second electrode layer are stacked on a substrate in order, the method comprising:
a step of forming a texture layer forming a continuous irregular configuration on the substrate by use of a transparent material in a visible light region before forming the first electrode layer, wherein
the forming of the texture layer includes forming the texture layer having an irregular configuration by applying the transparent material on the substrate using a spray.
